# EUROPÄISCHE PATENTSCHRIFT

(11) **EP 4 399 735 B1**
(45) Veröffentlichungstag und Bekanntmachung des Hinweises auf die Patenterteilung: **14.05.2025**
(21) Anmeldenummer: 22773502.4
(22) Anmeldetag: 06.09.2022
(51) Int. Cl.: H10N 60/20, G06N 10/40

(54) **ISOLATOR FÜR KRYOELEKTRISCHE CHIPS BEI EXTREM NIEDRIGEN TEMPERATUREN UNTER 10K**
INSULATOR FOR CRYOELECTRIC CHIPS AT EXTREMELY LOW TEMPERATURES BELOW 10 K
ISOLANT POUR PUCES CRYOÉLECTRIQUES À DES TEMPÉRATURES EXTRÊMEMENT BASSES INFÉRIEURES À 10 K

(30) Priorität: 06.09.2021 DE 102021123046
(43) Veröffentlichungstag der Anmeldung: 17.07.2024
(73) Patentinhaber: Forschungszentrum Jülich GmbH, 52428 Jülich (DE)
(72) Erfinder: BLUHM, Hendrik, 52425 Jülich (DE)
(74) Vertreter: Sonnenberg Harrison Partnerschaft mbB
(86) Internationale Anmeldenummer: PCT/EP2022/074704
(87) Internationale Veröffentlichungsnummer: WO 2023/031477

(56) Entgegenhaltungen:
- US-B1- 6 605 339
- ALIEV G ET AL: "Hypersonic acoustic mirrors and microcavities in porous silicon", APPLIED PHYSICS LETTERS, AMERICAN INSTITUTE OF PHYSICS, 2 HUNTINGTON QUADRANGLE, MELVILLE, NY 11747, vol. 96, no. 12, 22 March 2010 (2010-03-22), pages 124101 - 124101, XP012130564, ISSN: 0003-6951, DOI: 10.1063/1.3367747
- LANZILLOTTI-KIMURA N ET AL: "Nanophononic thin-film filters and mirrors studied by picosecond ultrasonics", APPLIED PHYSICS LETTERS, AMERICAN INSTITUTE OF PHYSICS, 2 HUNTINGTON QUADRANGLE, MELVILLE, NY 11747, vol. 96, no. 5, 1 February 2010 (2010-02-01), pages 53101 - 53101, XP012132057, ISSN: 0003-6951, DOI: 10.1063/1.3295701
- LANZILLOTTI-KIMURA N. D. ET AL: "Acoustic phonon nanowave devices based on aperiodic multilayers: Experiments and theory", PHYSICAL REVIEW B, vol. 76, no. 17, 26 June 2007 (2007-06-26), US, pages 67, XP093002563, ISSN: 1098-0121, DOI: 10.1103/PhysRevB.76.174301

## Beschreibung

### Technisches Gebiet

Die Erfindung betrifft ein Isolatorsystem zwischen zwei Chips, welche thermisch isoliert zueinander bei unterschiedlichen Temperaturen unterhalb von 10K betrieben werden, wobei Informationen zwischen einem ersten und einem zweiten Chip der beiden Chips über ein Verbindungssystem aus elektrischen Verbindungen ausgetauscht werden.

### Beschreibung

Herkömmliche Computer arbeiten mit Halbleiterbauteilen mit integrierten Schaltkreisen. Diese Schaltkreise arbeiten immer mit Systemen, welche auf einer logischen "0" oder "1" basieren - also Schalter "an" oder "aus". Bei Halbleiterspeichern wird dies dadurch realisiert, dass das Potential entweder oberhalb oder unterhalb eines Schwellwerts liegt. Diese zwei Zustände bilden die kleinste Einheit bei Computern und werden als "Bit" bezeichnet.

Diese Halbleiterbauteile bestehen oft aus dotierten Siliziumelementen, um die Schaltungen zu realisieren. So lassen sich beispielsweise Transistorschaltungen in solchen Halbleiterbauteilen anordnen und zu einem logischen Schaltkreis verknüpfen. Durch immer besser werdende chemische und physikalische Herstellungsverfahren können diese Halbleiterbauteile mittlerweile in immer extremerer Kompaktheit produziert werden. Diese Kompaktheit stößt aber an ihre physikalischen Grenzen. Sowohl die Dichte der Schaltungen als auch die Temperatur führen häufig zu Problemen in solchen Halbleiterbauteilen. So können insbesondere noch Optimierungen durch mehrere Schichtmodelle, höhere Schalttaktung oder auch bei der Wahl des Halbleitermaterials erzielt werden. Trotzdem reichen die Rechenleistungen für viele Anwendungen, wie z.B. in der kryptographischen Technologie oder bei Berechnung von Wetter- bzw. Klimamodellen wegen der enormen Datenmengen oft nicht aus.

Um die Rechenleistung erheblich zu erhöhen, sind seit langem Modelle für sogenannte Quantencomputer bekannt. Technisch ließen sie sich aus unterschiedlichen Gründen bislang jedoch noch nicht realisieren. Die Modelle von Quantencomputern sehen vor, dass quantenmechanische Zustände von Teilchen, wie z.B. Elektronen, ausgenutzt werden. Dabei wird ein quantenmechanisches System mit zwei Zuständen als kleinste Einheit zum Speichern von Informationen als "Qubit" bezeichnet. Ein Qubit wird beispielsweise durch den quantenmechanischen Zustand Spin "Up" und Spin "Down" definiert.

Das Prinzip von Elektronen-Spin-Qubits gleicht sich immer, unabhängig vom jeweils gewählten Materialsystem. Als Grundlage für die Bauelemente dienen dabei oft eine Halbleiter-Heterostruktur, eine Grenzfläche zwischen Halbleiter und Isolator, oder diverse Materialdefekte. Die Halbleiter-Heterostruktur beinhaltet ein zweidimensionales Elektronengas (2DEG). Halbleiter-Heterostrukturen sind monokristallin aufeinander gewachsene Schichten von Halbleitern mit unterschiedlicher Zusammensetzung. Diese Schichtstrukturen liefern zahlreiche technisch relevante Quantisierungseffekte bezüglich ihrer elektronischen und optischen Eigenschaften. Daher sind sie für die Herstellung mikroelektronischer Bauelemente besonders geeignet. Die derzeit wichtigste Materialkombination für die Herstellung von Halbleiter-Heterostrukturen für Qubits ist das System Si/SiGe.

Das Potenzial von Quantencomputern steckt in den sogenannten Quantenbits (auch Qubits genannt). Es gibt verschiedene Arten von Qubit-Technologien, die alle vor der gleichen Schwierigkeit stehen, dass nämlich ihre Zustände sehr instabil sind. Damit die Qubits für Rechenprozesse lange genug kontrollierbar bleiben, müssen die Qubits auf extrem niedrige (kryogene) Temperaturen, oft unter 0,1 K, gekühlt werden. Um die Qubits auch in großer Zahl an die notwendige Auslese- und Steuerelektronik anzuschließen, bedarf es einer sehr hohen Verbindungsdichte, welche zum Beispiel durch mikrofabrizierte Verbindungselemente erreicht wird. Für die Kontrollschaltungen ist dabei eine Dissipation erwartbar, welche die bei der Qubittemperatur verfügbare Kühlleistung deutlich übertrifft. Deshalb werden Verfahren bzw. Vorrichtungen benötigt, die gleichzeitig eine hohe Verbindungsdichte, wie auch eine thermische Isolation ermöglichen. Durch die höhere Betriebstemperatur (über 1 K) steht für die Kontrollschaltung eine um Größenordnungen höhere Kühlleistung zur Verfügung.

Thermische isolierende elektrische Verbindungen benötigen oft zum Erhalt der mechanischen Stabilität eine Stützstruktur mit ähnlichen strukturellen Eigenschaften, wie Silizium. Die Stützstruktur darf jedoch ebenfalls nur eine geringe Wärmeleitung haben.

### Stand der Technik

In Anzilotti-Kimura, N.D. [u.a.]: Acoustic phonon nanowave devices based on aperiodic multilayers: Experiment and theory; Physical Review B 76, 2007, No. 17, 174301 werden mehrschichtige akustische Nanowellenbauelemente, die auf aperiodischen Stapeln von GaAs- und AlAs-Schichten basieren beschrieben. Die mehrschichtige akustische Nanowellenbauelemente können mit der Standard-Molekularstrahlepitaxie (MBE)-Technologie hergestellt werden. Diese Nanostrukturen wurden entwickelt, um optimierte akustische Reflektivitätskurven im Terahertzbereich zu zeigen. Dabei werden verschiedene Techniken für das Design, die Optimierung und die Charakterisierung solcher akustischer Phonon-Bauelemente eingesetzt.

In Aliev, G. N. [u.a.]: Hypersonic acoustic mirrors and microcavities in porous silicon; Applied Physics Letters (APL), Vol 96, 2010, No. 12, 124101 werden akustische Hyperschallspiegel und Mikrokavitäten in porösem Silizium beschrieben. Periodische Festkörperstrukturen weisen Transmissionssperrbänder für Wellen bestimmter Frequenzen auf. Es wird die Durchführung und direkte Messung von akustischen Bandlücken in porösen Silizium-Mehrschichtstrukturen, die 50 dB-Sperrbänder für longitudinale akustische Wellen im Gigahertz-Bereich aufweisen, veranschaulicht. Außerdem wird die Realisierung einer akustischen Mikrokavitätsstruktur in porösem Silizium demonstriert.

Die De Boor, J. [u.a.]: Temperature and structure size dependence of the thermal conductivity of porous silicon in EPL (Europhysics Letters), Vol 96, 2011 No. 1, 16001 beschreibt die Temperatur- und Strukturgrößenabhängigkeit der Wärmeleitfähigkeit von porösem Silizium. Um das Potenzial von porösem Silizium als thermoelektrisches Material zu bewerten, wird dort dargestellt, wie Messungen der Wärmeleitfähigkeit in Abhängigkeit von der Temperatur und der durchschnittlichen Strukturgröße durchgeführt wurden. Es wird geschildert, wie Untersuchungen an Proben mit durchschnittlichen Strukturgrößen zwischen 7nm und 100nm eine deutliche Verringerung der Wärmeleitfähigkeit zeigen. Die Abhängigkeit von der Strukturgröße und der Temperatur wird durch ein einfaches kinetisches Modell erklärt, das auf der Verringerung der effektiven Phononen mittleren freien Weges beruht.

Aus Lanzilotti-Kimura, N.D. [u.a.]: Nanophononic thin-film filters and mirrors studied by picosecond ultrasonics in Applied Physics Letters (APL), Vol. 96, 2010, No. 5, 053101 sind nanophononische Dünnschichtfilter und Spiegel bekannt. Optimierte akustische Phonon-Dünnschichtfilter werden mit Pikosekunden-Ultraschall untersucht. Ein breitbandiger Spiegel und ein Farbfilter auf der Basis von aperiodischen Multischichten wurde optimiert, um in einem Subterahertzbereich zu arbeiten und wurde durch Molekularstrahlepitaxie hergestellt. Es wird dort veranschaulicht, wie zeitaufgelöste differentielle optische Reflektivität Experimente mit Pump- und Probepulsen durchgeführt wurden, die auf entgegengesetzte Seiten des Substrats einfielen. Darüber hinaus werden dort die Auswirkungen der freien Oberfläche und der Einfluss einer Al-Deckschicht auf das Verhalten der aperiodischen Bauelemente analysiert.

US 6 605 339 B1 zeigt eine Anordnung für kryogene Systeme, wo eine thermisch isolierende Schicht (unter anderem ein Bragg-Reflektor) auf mikroskopischen Säulen aufgelegt ist, um die thermische Leitfähigkeit so gering wie möglich zu halten.

Ein Problem beim Kontrollieren bzw. beim Auslesen von Qubits besteht darin, dass bislang keine Techniken bekannt sind, welche die erforderliche thermische Isolierung bei gleichzeitig hoher Verbindungsdichte bei den extrem tief liegenden Temperaturen unter -260° C ermöglichen. Dies ist aber eine Schlüsselkomponente für die Integration von Qubits und kryoelektrischen Schaltungen.

### Offenbarung der Erfindung

Aufgabe der Erfindung ist es daher, die Nachteile des Standes der Technik zu vermeiden und ein Isoliersystem mit entsprechender Verdrahtung zwischen zwei Chips zu schaffen, welche mit unterschiedlicher Temperatur unterhalb von 10K betrieben werden.

Erfindungsgemäß wird die Aufgabe dadurch gelöst, dass bei einem Isolatorsystem zwischen zwei Chips der eingangs genannten Art zur thermischen Isolation ein Bragg-Reflektor vorgesehen ist, welcher Durchgänge für die elektrischen Verbindungen aufweist.

Die Erfindung beruht auf dem Prinzip, dass das als Bragg-Reflektor fungierende Isolatorsystem zu einer hohen Phononenstreuung senkrecht zu dem Bragg-Reflektor führt, so dass die thermische Wärmeleitung stark unterdrückt wird. Dieses Isolatorsystem wird zwischen die zu isolierenden Chips platziert. Die elektrischen Verbindungen lassen sich zum Informationsaustausch mit hoher Verbindungsdichte durch das Isolatorsystem führen.

In einer vorteilhaften Ausgestaltung des erfindungsgemäßen Isolatorsystem besteht der Bragg-Reflektor aus einem Schichtsystem, dessen Schichten unterschiedliche physikalische Eigenschaften aufweisen. In einem solchen Schichtsystem kommt es zu geeigneter Interferenz, womit eine hohe Phononenstreuung einhergeht. Diese Phononenstreuung hat zur Folge hat, dass es nur zu einer geringen Wärmeleitung in dem als Bragg-Reflektor ausgebildeten Isolatorsystem kommt.

Eine weitere vorteilhafte Ausbildung des erfindungsgemäßen Isolatorsystems zwischen zwei Chips besteht darin, dass die Schichten des Schichtsystems unterschiedliche Materialien mit unterschiedlicher akustischer Impedanz aufweisen. Auch diese Maßnahme wird vorgenommen, um den Effekt der Interferenz zu verstärken, womit die Phononenstreuung des Materials nur eine geringere Wärmeleitung zulässt.

In einer besonderen Variante des erfindungsgemäßen Isolatorsystems ist die Dicke der Schichten des Schichtsystems unterschiedlich ausgestaltet. Dabei handelt es sich um eine weitere vorteilhafte Maßnahme an dem Isolatorsystem, um die Phononenstreuung über einen breiten Wellenlängenbereich zu verstärken, wodurch die Wärmeleitfähigkeit bei den kryogenen Temperaturen weiter reduziert wird. Beispielsweise kann die Dicke von Schicht zu Schicht um ca. 1% in dem Schichtsystem vergrößert werden.

Weiterhin bestehen in einer bevorzugten Ausgestaltung des erfindungsgemäßen Isolatorsystems die Schichten aus porösem Silizium. Komplementär können poröse Materialien oder Materialien mit geringer Wärmeleitfähigkeit, z.B. gesinterte Materialien, verwendet werden. Grundsätzlich hat sich hier poröses Silizium als besonders geeignet für diese Anwendung herausgestellt. Es können auch verschiedene Materialien mit geringer Wärmeleitfähigkeit kombiniert werden, um unterschiedliche Phononenenergien abzudecken.

Eine vorteilhafte Ausgestaltung des erfindungsgemäßen Isolatorsystems besteht darin, dass der erste Chip eine Kontroll- und Steuerschaltung und der zweite Chip eine Recheneinheit aufweist. Hierbei handelt es sich um eine Maßnahme, die das Isolatorsystem für Quantencomputer besonders einsetzbar macht. Die Kontroll- und Steuerschaltung wird nämlich nicht bei so tiefen Temperaturen, üblicherweise ca. 2K, betrieben, wohingegen die Qubit-Chips üblicherweise nur bei ca. 100mK stabile und verwertbare Zustände aufweisen. Insofern besteht hier regelmäßig eine Temperaturdifferenz von wenigstens einer Größenordnung. In Experimenten, in welchen Qubits bei einigen 100mK betrieben werden, liegt eine Temperaturdifferenz von typischerweise einer Größenordnung vor. Mit dem erfindungsgemäßen Isolatorsystem zwischen den beiden Chips findet nun nur noch ein sehr geringer Wärmeaustausch statt.

Damit die elektrischen Verbindungen selbst keine Wärme erzeugen und ebenfalls wenig wärmeleitend sind, sind bei dem erfindungsgemäßen Isolatorsystem die elektrischen Verbindungen supraleitend, insbesondere als supraleitende Vias - Kontaktverbindungen -, ausgebildet. Bei den supraleitenden Verbindungen wird praktisch keine Wärme generiert und haben gleichzeitig eine nur geringe Wärmeleitung, so dass sie keinen thermischen Einfluss auf die Anordnung nehmen können.

In einer bevorzugten Ausbildung des erfindungsgemäßen Isolatorsystems sind Festkörper mit Kanälen mit superfluidem Helium und/oder ein Festkörper mit hoher Wärmeleitfähigkeit zur Wärmeableitung vorgesehen. Hierdurch kann die in dem Schichtsystem anfallende Wärme von dem Isolatorsystem nach außen abgeführt werden. Die Isolationswirkung wird so maximiert. Dabei können die Kanäle mit superfluidem Helium auch an den Chips entlang und/oder durch die Chips geführt werden. Bei geeigneter Anordnung der Kanäle, können diese dann auch zur Wärmeableitung für die Chips herangezogen werden. Alternativ oder in Kombination kann auch ein Festkörper, wie z.B. Kupfer, zum Ableiten der Wärme aus dem System verwendet werden.

Eine bevorzugte Ausgestaltung des erfindungsgemäßen Isolatorsystems besteht darin, dass Bragg-Reflektoren in Reihe geschaltet angeordnet sind. Durch die kaskadenförmige Anordnung der Bragg-Reflektoren können Chips auch mit größere Temperaturdifferenzen, welche dabei auch über mehrere Größenordnungen gehen können, gegeneinander isoliert werden. Ein Wärmeaustausch kann mit dieser Maßnahme noch einmal erheblich minimiert werden.

In einer weiteren vorteilhaften Ausgestaltung des erfindungsgemäßen Isolatorsystems sind die Festkörper mit den Kanälen mit superfluidem Helium und/oder die Festkörper mit hoher Wärmeleitfähigkeit, wie z.B. Kupfer, zwischen den in Reihe geschalteten Bragg-Reflektoren zur Wärmeableitung vorgesehen. Diese Maßnahme dient dazu die in Reihe angeordneten Bragg-Reflektoren bei der Kühlleistung zu optimieren, indem jeweils die auftretende Wärme eines jeden Bragg-Reflektors abgeführt wird. Hierdurch erhält man somit eine weitere Verbesserung der thermischen Isolation.

Weitere Ausgestaltungen und Vorteile ergeben sich aus dem Gegenstand der Unteransprüche sowie den Zeichnungen mit den dazugehörigen Beschreibungen. Ausführungsbeispiele sind nachstehend unter Bezugnahme auf die beigefügten Zeichnungen näher erläutert. Die Erfindung soll nicht alleine auf diese aufgeführten Ausführungsbeispiele beschränkt werden. Sie dienen lediglich zur näheren Erläuterung der Erfindung. Die vorliegende Erfindung soll sich auf alle Gegenstände beziehen, die jetzt und zukünftig der Fachmann als naheliegend zur Realisierung der Erfindung heranziehen würde. Die folgende ausführliche Beschreibung bezieht sich auf die derzeit besten möglichen Ausführungsarten der Offenbarung. Die Beschreibung ist daher nicht in einem einschränkenden Sinn zu verstehen, sondern dient lediglich der Veranschaulichung der allgemeinen Prinzipien der Erfindung, da der Umfang der Erfindung durch die beigefügten Ansprüche definiert wird.

### Liste der Figuren

Fig. 1 zeigt in einer Prinzipskizze ein Ausführungsbeispiel von zwei verdrahteten Chips, welche bei unter 10K mit unterschiedlichen Temperaturen betrieben werden.
Fig. 2 zeigt als Prinzipskizze den vertikalen Schnitt eines Schichtsystems, welches die beiden verdrahteten Chips gegeneinander isoliert.
Fig. 3 zeigt in einer schematischen Prinzipskizze mehrere Bragg-Reflektoren in Reihe geschaltet, welche die beiden Chips voneinander isolieren.

### Bevorzugtes Ausführungsbeispiel

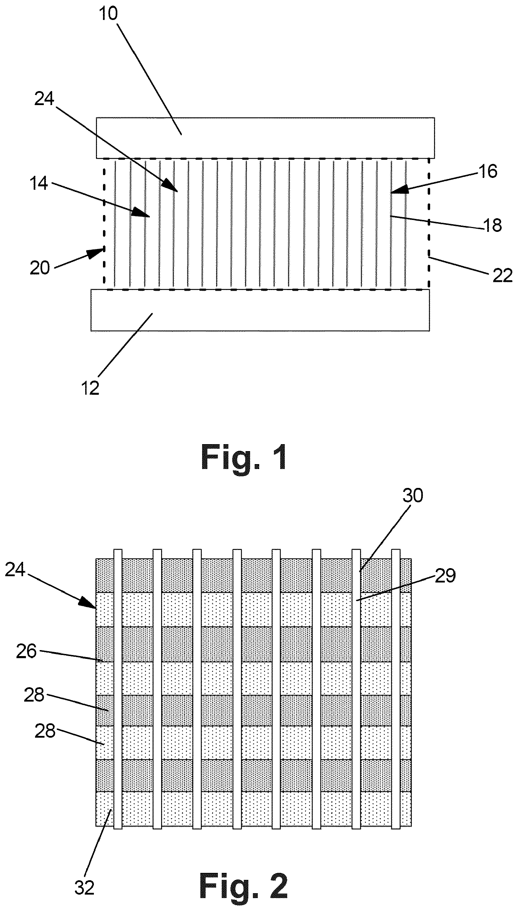

In Fig. 1 wird mit 10 ein erster Chip und mit 12 ein zweiter Chip in einem Quantencomputer bezeichnet. In dem ersten Chip 12 ist eine Kontroll- und Ausleseschaltung integriert. Vorzugsweise ist dieser erste Chip 10 als CMOS (Complementary Metal Oxid Semiconductor) ausgestaltet. Der zweite Chip 12 ist im vorliegenden Ausführungsbeispiel ein Qubit-Chip. Die Zustände der Qubit-Chips sind relativ instabil. Damit sie kontrollierbar bleiben, wird der Qubit-Chip 12 auf extrem niedrige - kryogene - Temperaturen unter 0,1 K gekühlt.

Entsprechend werden die beiden Chips 10, 12 bei unterschiedlichen Temperaturen unterhalb von 10K betrieben. Dabei muss der erste Chip 10 nicht ganz so tief herabgekühlt sein, wie der zweite Chip 12. In einem Anwendungsfall befindet sich der erste Chip 10 in einem Temperaturbereich von ca. 2K. Die dissipierte Leistung eines solchen Chips 10 beträgt dabei ca. 1W. Der zweite Chip wird dann bei ca. 100mK betrieben. Die Kühlleistung beträgt hier ca. 1mW.

Die beiden Chips 10, 12 sind über ein Verbindungssystem 14, miteinander verbunden. Die elektrischen Verbindungen 16 bestehen aus Signalleitungen 18, welche eine hohe Verbindungsdichte aufweisen. Bei diesem Verbindungssystem 14 sind mehr als 10⁶ Verbindungen möglich und vorgesehen. Über die Signalleitungen 18 tauschen die beiden Chips 10, 12 Informationen als Signale, insbesondere zum Auslesen und zum Steuern bzw. zum Kontrollieren, aus. Die Signalleitungen 18 sind supraleitend ausgebildet und haben dementsprechend eine geringe thermische Leitfähigkeit.

Durch die höhere Betriebstemperatur von über 1 K steht für die Kontrollschaltung eine um Größenordnungen höhere Kühlleistung zur Verfügung. Zwischen den Chips 10 und 12 ist ein thermisches Isolatorsystem 20 vorgesehen. Das thermische Isolatorsystem 20 wird durch gestrichelte Linien 22 angedeutet und in Fig. 2 näher erläutert. Das thermische Isolatorsystem 20 ist als Bragg-Reflektor 24 ausgebildet.

In Fig. 2 wird das thermische Isolatorsystem 20 schematisch im Schnitt dargestellt. Das Isolatorsystem 20 besteht aus einem als den Bragg-Reflektor 24 fungierenden Schichtsystem 26. Das so ausgebildete Isolatorsystem 20 führt zu einer hohen Phononenstreuung senkrecht zu dem Bragg-Reflektor 24, so dass die thermische Wärmeleitung stark unterdrückt wird. Das Schichtsystem 26 besteht aus Schichten 28 mit unterschiedlichen physikalischen Eigenschaften. Die Dicke der Schichten 28 des Schichtsystems 26 variieren und sind so gewählt, dass die Phononentransmission über den gesamten relevanten Wellenlängenbereich hinreichend klein ist. Die Schichten 28 des Schichtsystems 26 bestehen aus verschiedenen Materialien mit unterschiedlicher akustischer Impedanz.

In diesem Ausführungsbeispiel werden zur besseren Übersicht nur einige wenige Schichten 28 dargestellt. Tatsächlich handelt es sich aber z.B. um ca. fünfhundert Schichten 28. Die Dicke der Schichten 28 nimmt von Schicht zu Schicht um ca. 1 % zu. Durch Interferenz wird eine hohe Phononenstreuung und damit auch das Isolatorsystem 20 mit geringer Wärmeleitung erreicht. Simulationen ergeben, dass auch eine geringere Anzahl von Schichten 28, z.B. zwanzig, ausreicht, wobei die Zunahme der Dicke der Schichten 28 von Doppelschicht zu Doppelschicht größer ausfällt, z.B. 40%, um eine geringe Wärmeleitung zu erreichen.

Es sind Durchgänge 29 durch das Schichtsystem 26 gezeigt. Dabei handelt es sich um innen leitend beschichtete Löcher 30 jeweils in einer Schicht 28, die als Signalleitungen 18 durch das Schichtsystem 26 geführt sind. Die Signalleitungen 18 tauschen die Informationssignale zwischen dem ersten Chip 10 und dem zweiten Chip 12 aus. Die Schichten 28 bilden dabei die für die supraleitenden Signalleitungen 18 erforderliche Stützstruktur 32. Die Anordnung der Leitungen erlaubt eine Verbindungsdichte in einer Größenordnung von mehr als 10⁶ elektrischer Signalleitungen.

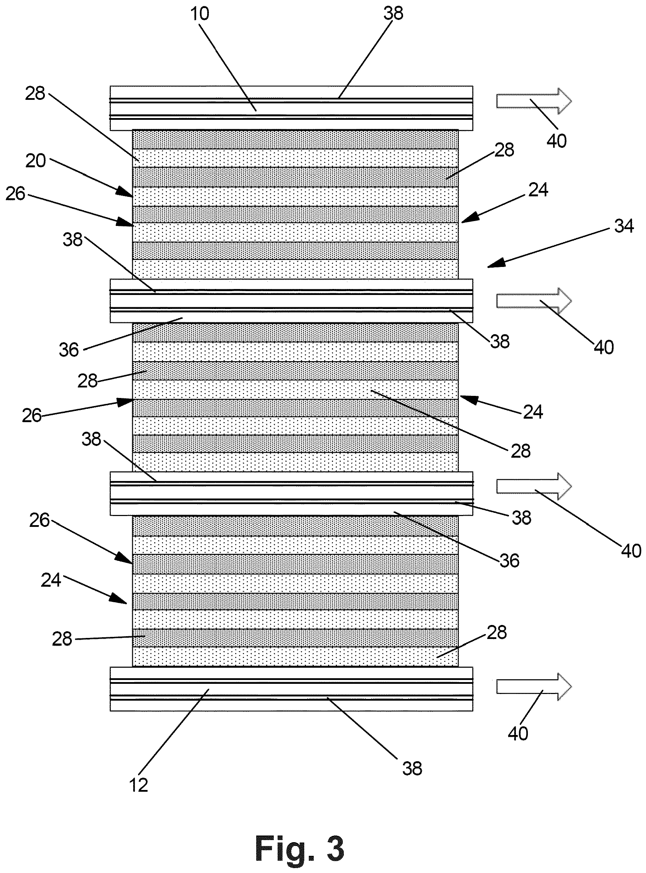

In Fig. 3 wird in einer schematischen Prinzipskizze ein Isolatorsystem 20 gezeigt, bei dem mehrere Bragg-Reflektoren 24 in Reihe geschaltet sind, welche die beiden Chips 10, 12 voneinander thermisch isolieren. Durch diese kaskadenförmige Anordnung 34 können auch größere Temperaturdifferenzen überbrückt werden. Zwischen den Schichtsystemen 26, die die Bragg-Reflektoren bilden, sind Festkörper 36 mit guter Wärmeleitung vorgesehen. Diese Festkörper 36 führen die Wärme aus dem Isolatorsystem 20 heraus. Um den Effekt der Wärmeleitung aus dem Isolatorsystem 20 heraus zu verstärken, sind Kanäle 38 in den wärmeleitenden Festkörpern 36 vorgesehen, durch die suprafluides Helium geleitet wird. Dies beschleunigt die Wärmeabfuhr. Die jeweils abgeführte Wärmemenge Q aus dem Isolatorsystem 20 wird mit Pfeilen 40 symbolisiert.

### Bezugszeichenliste

- 10: Erster Chip
- 12: Zweiter Chip
- 14: Verbindungssystem
- 16: Elektrische Verbindungen
- 18: Signalleitungen
- 20: Isolatorsystem
- 22: gestrichelte Linien
- 24: Bragg-Reflektor
- 26: Schichtsystem
- 28: Schichten
- 29: Durchgänge
- 30: Beschichtete Löcher
- 32: Stützstruktur
- 34: Kaskadenförmige Anordnung
- 36: Wärmeleitende Festkörper
- 38: Kanäle
- 40: Pfeile

## Patentansprüche

1. Isolatorsystem (20) zwischen zwei Chips (10, 12), welche thermisch isoliert zueinander bei unterschiedlichen Temperaturen unterhalb von 10K betrieben werden, wobei Informationen zwischen einem ersten Chip (10) und einem zweiten Chip (12) der beiden Chips (10, 12) über ein Verbindungssystem (14) aus elektrischen Verbindungen (16) ausgetauscht werden, weiter umfassend einen Bragg-Reflektor (24) zur thermischen Isolation, welcher Durchgänge (29) für die elektrischen Verbindungen (16) aufweist.

2. Isolatorsystem (20) zwischen zwei Chips (10, 12) nach Anspruch 1, bei welchem der Bragg-Reflektor (24) aus einem Schichtsystem (26) besteht, dessen Schichten (28) unterschiedliche physikalische Eigenschaften aufweisen.

3. Isolatorsystem (20) zwischen zwei Chips (10, 12) nach Anspruch 2, bei welchem die Schichten (28) des Schichtsystems (26) unterschiedliche Materialien mit unterschiedlicher akustischer Impedanz aufweisen.

4. Isolatorsystem (20) zwischen zwei Chips (10, 12) nach einem der Ansprüche 1 bis 3, bei welchem die Dicke der Schichten (28) des Schichtsystems (26) unterschiedlich ausgestaltet ist.

5. Isolatorsystem (20) zwischen zwei Chips (10, 12) nach einem der Ansprüche 1 bis 4, bei welchem eine Schicht (28) poröses Material und/oder poröses Silizium enthält.

6. Isolatorsystem (20) zwischen zwei Chips (10, 12) nach einem der Ansprüche 1 bis 5, bei welchem der erste Chip (10) eine Kontroll- und Steuerschaltung und der zweite Chip (12) eine Recheneinheit aufweist.

7. Isolatorsystem (20) zwischen zwei Chips (10, 12) nach einem der Ansprüche 1 bis 6, bei welchem die elektrischen Verbindungen (16) als supraleitend, insbesondere supraleitende Vias, ausgebildet sind.

8. Isolatorsystem (20) zwischen zwei Chips (10, 12) nach einem der Ansprüche 1 bis 7, weiter umfassend Festkörper (36) mit Kanälen (38) mit superfluidem Helium und/oder ein Festkörper mit hoher Wärmeleitfähigkeit zur Wärmeableitung.

9. Isolatorsystem (20) zwischen zwei Chips (10, 12) nach Anspruch 8, bei welchem Bragg-Reflektoren (24) in Reihe geschaltet angeordnet sind.

10. Isolatorsystem (20) zwischen zwei Chips (10, 12) nach Anspruch 9, wobei die Festkörper (36) mit den Kanälen (38) mit superfluidem Helium und/oder die Festkörper (36) mit hoher Wärmeleitfähigkeit zwischen den in Reihe geschalteten Bragg-Reflektoren (24) zur Wärmeableitung angeordnet sind.

## Claims

1. An isolator system (20) between two chips (10, 12), which are operated thermally insulated from one another at different temperatures below 10K, wherein information is exchanged between a first chip (10) and a second chip (12) of the two chips (10, 12) via a connection system (14) of electrical connections (16), further comprising a Bragg reflector (24) for thermal insulation, which has passages (29) for the electrical connections (16).

2. The isolator system (20) between two chips (10, 12) according to claim 1, wherein the Bragg reflector (24) consists of a system of layers (26), the layers (28) of which have different physical properties.

3. The isolator system (20) between two chips (10, 12) according to claim 2, wherein the layers (28) of the system of layers (26) have different materials with different acoustic impedance.

4. The isolator system (20) between two chips (10, 12) according to one of claims 1 to 3, wherein the thickness of the layers (28) of the system of layers (26) is configured differently.

5. The isolator system (20) between two chips (10, 12) according to one of claims 1 to 4, wherein a layer (28) contains porous material and/or porous silicon.

6. The isolator system (20) between two chips (10, 12) according to one of claims 1 to 5, wherein the first chip (10) has a monitoring and control circuit and the second chip (12) has a computing unit.

7. The isolator system (20) between two chips (10, 12) according to one of claims 1 to 6, wherein the electrical connections (16) are configured to be superconducting, in particular as superconducting vias.

8. The isolator system (20) between two chips (10, 12) according to one of claims 1 to 7, further comprising solids (36) with channels (38) with superfluid helium and/or a solid with high thermal conductivity for heat dissipation.

9. The isolator system (20) between two chips (10, 12) according to claim 8, wherein Bragg reflectors (24) are arranged to be connected in series.

10. The isolator system (20) between two chips (10, 12) according to claim 9, wherein the solids (36) with the channels (38) with superfluid helium and/or the solids (36) with high thermal conductivity are arranged between the Bragg reflectors (24) connected in series for heat dissipation.

## Revendications

1. Système d'isolateur (20) entre deux puces (10, 12), lesquelles sont utilisées de manière thermiquement isolée l'une de l'autre à des températures différentes inférieures à 10 K, dans lequel des informations sont échangées entre une première puce (10) et une deuxième puce (12) des deux puces (10, 12) par le biais d'un système de connexion (14) comprenant des connexions électriques (16), le système d'isolateur (20) comprenant en outre un réflecteur de Bragg (24) pour une isolation thermique, ledit réflecteur de Bragg présentant des passages (29) pour les connexions électriques (16).

2. Système d'isolateur (20) entre deux puces (10, 12) selon la revendication 1, dans lequel le réflecteur de Bragg (24) est constitué d'un système de couches (26), dont les couches (28) présentent des propriétés physiques différentes.

3. Système d'isolateur (20) entre deux puces (10, 12) selon la revendication 2, dans lequel les couches (28) du système de couches (26) présentent des matériaux différents avec une impédance acoustique différente.

4. Système d'isolateur (20) entre deux puces (10, 12) selon l'une quelconque des revendications 1 à 3, dans lequel l'épaisseur des couches (28) du système de couches (26) est configurée différemment.

5. Système d'isolateur (20) entre deux puces (10, 12) selon l'une quelconque des revendications 1 à 4, dans lequel une couche (28) comprend un matériau poreux et/ou du silicium poreux.

6. Système d'isolateur (20) entre deux puces (10, 12) selon l'une quelconque des revendications 1 à 5, dans lequel la première puce (10) présente un circuit de contrôle et de commande et la deuxième puce (12) présente une unité de calcul.

7. Système d'isolateur (20) entre deux puces (10, 12) selon l'une quelconque des revendications 1 à 6, dans lequel les connexions électriques (16) sont réalisées de manière supraconductrice, en particulier sous forme de vias supraconducteurs.

8. Système d'isolateur (20) entre deux puces (10, 12) selon l'une quelconque des revendications 1 à 7, comprenant en outre des corps solides (36) avec des canaux (38) avec de l'hélium superfluide et/ou un corps solide avec une conductivité thermique élevée pour une dissipation de chaleur.

9. Système d'isolateur (20) entre deux puces (10, 12) selon la revendication 8, dans lequel des réflecteurs de Bragg (24) sont disposés de manière à être connectés en série.

10. Système d'isolateur (20) entre deux puces (10, 12) selon la revendication 9, dans lequel les corps solides (36) avec les canaux (38) avec de l'hélium superfluide et/ou les corps solides (36) avec une conductivité thermique élevée sont disposés entre les réflecteurs de Bragg (24) connectés en série pour une dissipation de chaleur.
